# EUROPEAN PATENT SPECIFICATION

(11) **EP 2 362 412 B1**
(45) Date of publication and mention of the grant of the patent: **08.04.2020**
(21) Application number: 11155069.5
(22) Date of filing: 18.02.2011
(51) Int. Cl.: H01L 21/02

(54) **Method of growing nitride semiconductor**
Verfahren zum Aufwachsen eines Nitridhalbleiters
Procédé de croissance de semi-conducteur à nitrure

(30) Priority: 19.02.2010 KR 20100015247; 24.08.2010 KR 20100082085
(43) Date of publication of application: 31.08.2011
(73) Proprietor: Samsung Electronics Co., Ltd., Suwon-si, Gyeonggi-do, 443-742 (KR)
(72) Inventor: Park, Sung-soo, 449-712 Gyeonggi-do (KR); Lee, Moon-sang, 449-712 Gyeonggi-do (KR)
(74) Representative: Elkington and Fife LLP

(56) References cited:
- EP-A1- 1 796 180
- WO-A1-2009/015350
- US-A1- 2007 072 320
- US-A1- 2007 141 823
- US-B1- 6 528 394
- LAHRECHE H ET AL: "Growth of high-quality GaN by low-pressure metal-organic vapour phase epitaxy (LP-MOVPE) from 3D islands and lateral overgrowth", JOURNAL OF CRYSTAL GROWTH, ELSEVIER, AMSTERDAM, NL, vol. 205, no. 3, 1 September 1999 (1999-09-01), pages 245-252, XP004181586, ISSN: 0022-0248, DOI: DOI:10.1016/S0022-0248(99)00299-7
- HUANG H-H ET AL: "Strain-reduced GaN thick-film grown by hydride vapor phase epitaxy utilizing dot air-bridged structure", JOURNAL OF CRYSTAL GROWTH, ELSEVIER, AMSTERDAM, NL, vol. 311, no. 10, 1 May 2009 (2009-05-01), pages 3029-3032, XP026140928, ISSN: 0022-0248, DOI: DOI:10.1016/J.JCRYSGRO.2009.01.071 [retrieved on 2009-01-20]
- PIERRE GIBART ET AL: "Metal organic vapour phase epitaxy of GaN and lateral overgrowth; Metal organic vapour phase epitaxy", REPORTS ON PROGRESS IN PHYSICS, INSTITUTE OF PHYSICS PUBLISHING, BRISTOL, GB, vol. 67, no. 5, 1 May 2004 (2004-05-01), pages 667-715, XP020025058, ISSN: 0034-4885, DOI: DOI:10.1088/0034-4885/67/5/R02
- KUSAKABE K ET AL: "CHARACTERIZATION OF OVERGROWN GAN LAYERS ON NANO-COLUMNS GROWN BY RF-MOLECULAR BEAM EPITAXY", JAPANESE JOURNAL OF APPLIED PHYSICS, JAPAN SOCIETY OF APPLIED PHYSICS, JP, vol. 40, no. 3A, PART 02, 1 March 2001 (2001-03-01), pages L192-L194, XP001077931, ISSN: 0021-4922, DOI: 10.1143/JJAP.40.L192

## Description

The present disclosure relates to methods of growing a nitride semiconductor layer.

Electronic industries using nitride semiconductors have been considered as suitable fields for developing and growing the green industries. In particular, Gallium nitride (GaN), as a nitride semiconductor, is widely used in fabrication of a blue light-emitting diode which is one of core components of a high-power electronic device. The high-power electronic device commonly includes red, green, and/or blue light-emitting diodes (LED) as core components. A blue LED fabricated with the GaN has superior brightness, lifespan, and internal quantum efficiency compare to the conventional blue light-emitting device fabricated with Zinc selenide (ZnSe) due to excellent physical and chemical properties of the GaN. The GaN has a direct transition bandgap structure and the bandgap is adjustable from about 1.9 to about 6.2 eV by using an alloy such as In or Al. Therefore, the GaN may be used for light devices. In addition, the GaN has a high breakdown voltage and is stable at high temperatures, and thus, may be used in various fields such as high power devices and high-temperature electronic devices. For example, the GaN may be applied in large electronic signs using full-color displays, traffic lights, light sources of optical recording media, and high power transistors for vehicle engines. A LED fabricated using a GaN substrate has less defects, identical refractive index in the GaN substrate and the device layer, and a thermal conductivity that is four-times greater than that of sapphire. Thus, GaN is an essential element for fabricating high power LEDs.

H. Lahrèche et al. in the Journal of Crystal Growth 205 (1999) pages 245-252 disclose a growth method for obtaining high structural quality GaN films on sapphire by low-pressure metal-organic vapour phase epitaxy achieved by lateral overgrowth starting from self-organized islands on a GaN layer.

US 2007/0072320 A1 discloses a two-step method of manufacturing a low defect density GaN material comprising growing epitaxial layers of GaN with differences in growing conditions. The first step takes place under growing conditions that induce island features formation whilst the second step takes place under growing conditions to enhance lateral growth until coalescence.

H. H. Huang et al. in Journal of Crystal Growth 311 (2009) pages 3029-3032 disclose a 300 µm thick GaN film with a 1.5 inch diameter formed by hydride vapor phase epitaxy.

WO 2009/015350 A1 discloses methods for fabricating substantially continuous layers of group III nitride semiconductor material having low defect densities. The methods include epitaxial growth nucleating and/or seeding on the upper portions of a plurality of islands or pillars of a group III nitride material that are irregularly arranged on a template structure.

US 6,528,394 discloses a method of growing a gallium nitride film using an aluminium nitride seed layer.

US2007/0141823 teaches a method of growing a gallium nitride bulk layer on a transitional gallium nitride layer on a nucleation gallium nitride layer on an aluminium nitride layer on a substrate.

EP 1796180 discloses growing a nitride semiconductor layer on sapphire using MBE by creating vacancies in the substrate surface, forming AlN seeds in the vacancies, growing GaN columnar crystals less than 400nm wide from the seeds and growing the nitride layer from the columnar crystals. HVPE may be used instead of MBE.

KUSAKABE K ET AL; JAPANESE JOURNAL OF APPLIED PHYSICS, vol. 40, no. 3A, PART 02, pages L192-L194; March 2001; XP001077931 discloses growing a GaN semiconductor layer on sapphire using MBE by creating vacancies in the substrate surface, forming AlN seeds in the vacancies, growing 100nm diameter GaN columnar crystals, spaced by under 50nm, from the seeds, growing the nitride layer from the columnar crystals, and peeling off the overgrown nitride layer.

Provided are methods of growing a nitride semiconductor layer, which may grow a nitride semiconductor layer without forming cracks. The cracks are generated due to the strain on interfaces caused by the difference between lattice constants or thermal expansion coefficients of the nitride semiconductor layer and a substrate. A nitride semiconductor substrate may be obtained by the growing methods.

Additional aspects will be set forth in part in the description which follows and, in part, will be apparent from the description, or may be learned by practice of the presented embodiments.

According to an aspect of the present invention, there is provided a method of growing a nitride semiconductor layer according to claim 1.

The method may further include forming a stress relaxation layer in which the nitride semiconductor dots are connected each other during growing of the nitride semiconductor layer.

The nitride semiconductor layer may have a thickness that is equal to or greater than a thickness of the stress relaxation layer.

A thickness of the stress relaxation layer may be about 1 µm to 100 µm. The nitride semiconductor layer is formed by using a halide vapor phase epitaxy (HVPE) method.

The nitride semiconductor dots may be formed in-situ when the nitride semiconductor layer is grown on the substrate by using the HVPE method.

The nitride semiconductor dots may be arranged in a direction.

A thickness of the grown nitride semiconductor layer may depend on a size of the nitride semiconductor dots.

The nitride semiconductor dots may mostly have sizes of about 0.4 µm or greater.

The nitride semiconductor dots may mostly have sizes of about 0.4 µm to about 0.8 µm. Here, the thickness of the grown nitride semiconductor layer may be about 100 µm to about 1000 µm.

The nitride semiconductor dots may mostly have sizes of about 0.4 µm or less. Here, the thickness of the grown nitride semiconductor layer may be about 10 µm or less.

The nitride semiconductor layer may include gallium nitride (GaN).

The nitride semiconductor dots may have hexagonal shapes.

The substrate is a sapphire substrate.

The nitride semiconductor layer may be separated from the substrate by a laser liftoff method to be used as a nitride semiconductor substrate.

The nitride semiconductor substrate may be a GaN substrate.

The nitride semiconductor dots may be near or on a surface of the nitride semiconductor layer.

These and/or other aspects will become apparent and more readily appreciated from the following description of the embodiments, taken in conjunction with the accompanying drawings of which:
FIG. 1 is a schematic diagram illustrating a method of growing GaN on a sapphire substrate according to a method of growing a nitride semiconductor layer and an embodiment of the present invention;
FIG. 2 is a schematic diagram of a GaN layer separated from the sapphire substrate;
FIG. 3 is a schematic diagram of GaN dots formed on the sapphire substrate;
FIG. 4A is a scanning electron microscope (SEM) image of ALN nanodots on a sapphire substrate;
FIGS. 4B and 4C are scanning electron microscope (SEM) images showing GaN dots grown on a sapphire substrate;
FIG. 5 is an optical microscope image showing a stress relaxation layer formed between the GaN dots used as cores on a sapphire substrate, and a GaN layer on the GaN dots and the stress relaxation layer; and
FIG. 6 is an optical image showing thick GaN/sapphire layers having diameters of about 3 inches and about 4 inches, which are grown from GaN dots according to the method of growing the nitride semiconductor layer of the present embodiment.

Those skilled in the art will appreciate that the figures are not intended to be drawn to any particular scale; nor are the figures intended to illustrate every embodiment of the invention. The invention is not limited to the exemplary embodiments depicted in the figures or the specific components, shapes, relative sizes, ornamental aspects or proportions shown in the figures.

Various example embodiments will now be described more fully with reference to the accompanying drawings in which some example embodiments are shown. However, specific structural and functional details disclosed herein are merely representative for purposes of describing example embodiments. Thus, the invention may be embodied in many alternate forms and should not be construed as limited to only example embodiments set forth herein. Therefore, it should be understood that there is no intent to limit example embodiments to the particular forms disclosed, but on the contrary, example embodiments are to cover all modifications, equivalents, and alternatives falling within the scope of the claimed invention.

In the drawings, the thicknesses of layers and regions may be exaggerated for clarity, and like numbers refer to like elements throughout the description of the figures.

Although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or" includes any and all combinations of one or more of the associated listed items.

It will be understood that, if an element is referred to as being "connected" or "coupled" to another element, it can be directly connected, or coupled, to the other element or intervening elements may be present. In contrast, if an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," if used herein, specify the presence of stated features, integers, steps, operations, elements and/or components, but do not preclude the presence or addition of one or more other features, integers, steps, operations, elements, components and/or groups thereof.

Spatially relative terms (e.g., "beneath," "below," "lower," "above," "upper" and the like) may be used herein for ease of description to describe one element or a relationship between a feature and another element or feature as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, for example, the term "below" can encompass both an orientation that is above, as well as, below. The device may be otherwise oriented (rotated 90 degrees or viewed or referenced at other orientations) and the spatially relative descriptors used herein should be interpreted accordingly.

Example embodiments are described herein with reference to cross-sectional illustrations that are schematic illustrations of idealized embodiments (and intermediate structures). As such, variations from the shapes of the illustrations as a result, for example, of manufacturing techniques and/or tolerances, may be expected. Thus, example embodiments should not be construed as limited to the particular shapes of regions illustrated herein but may include deviations in shapes that result, for example, from manufacturing. For example, an implanted region illustrated as a rectangle may have rounded or curved features and/or a gradient (e.g., of implant concentration) at its edges rather than an abrupt change from an implanted region to a non-implanted region. Likewise, a buried region formed by implantation may result in some implantation in the region between the buried region and the surface through which the implantation may take place. Thus, the regions illustrated in the figures are schematic in nature and their shapes do not necessarily illustrate the actual shape of a region of a device and do not limit the scope.

It should also be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In order to more specifically describe example embodiments, various aspects will be described in detail with reference to the attached drawings. However, the present invention is not limited to example embodiments described.

Gallium nitride (GaN), as one of nitride semiconductors, has a bandgap energy of about 3.39 eV and is a wide bandgap material that is a direct transition type. Thus, the GaN is suitable for a light-emitting device of a short-wavelength.

Growth of a single crystal of GaN in a liquid phase generally requires a high temperature of about 1500°C or higher and a nitrogen atmosphere of about 20,000 atm in order to obtain a high nitrogen vapor pressure at the melting point. Therefore, it is difficult to mass-produce the single crystal of GaN by using the growth method in the liquid phase. In addition, the currently available size of the single crystal GaN by the growth method in the liquid phase is about 100 mm² which may not be large enough to be used in fabrication of a light-emitting device.

A GaN thin film is also grown by vapor deposition methods employing a heterogeneous substrate, such as a metal organic chemical vapor deposition (MOCVD) method or a hydride or halide vapor phase epitaxy (HVPE) method. Sapphire is usually used for the heterogeneous substrate in fabrication of the GaN thin film, because the sapphire is stable at a high temperature and it is relative inexpensive.

However, it is difficult growing a high quality GaN film on the sapphire substrate, because of a difference of about 16 % in lattice constants and a difference of about 35 % in coefficients of thermal expansion of the sapphire substrate and the GaN thin film. Due to the differences, there exists strain on the interface between the sapphire substrate and the GaN thin film, which causes lattice defects in the GaN crystal or cracks in the interface and results in reduction of the lifespan of a device fabricated on the GaN thin film. In addition, the light-emitting efficiency of a light-emitting diode (LED) fabricated on the sapphire substrate is limited due to a difference between refractive indexes of the sapphire substrate and the GaN thin film, as well as, the stress induced defects in the GaN crystal. To address the above problems, it is desired to use a substrate having similar or same characteristics with the GaN thin film, such as a GaN substrate, and to fabricate a device on the nitride semiconductor substrate (GaN substrate) by a homoepitaxy process.

According to the inventive method of growing a nitride semiconductor layer, the nitride semiconductor layer is grown on the substrate without the cracks by eliminating the differences of the lattice constants and the thermal expansion coefficients between the substrate and the nitride semiconductor layer formed by the HVPE method.

A substrate is prepared to grow the nitride semiconductor layer. Nitride semiconductor dots are formed on the substrate. The nitride semiconductor dots may be arranged in a direction. The nitride semiconductor dots may reduce the cracks generated due to the differences between the lattice constants and/or the thermal expansion coefficients of the substrate and a nitride semiconductor layer/film. The nitride semiconductor layer may be grown as a single crystal by using the nitride semiconductor dots as cores. Although example embodiments are described with respect to nitride semiconductor layers, methods of growing semiconductor layers according to example embodiments may be widely applied to the growth of a material layer on a material layer with different properties (e.g., thermal expansion coefficients and/or lattice constants).

The vertical and horizontal growth speeds of the nitride semiconductor layer can be controlled by adjusting a ratio of a group III-V semiconductor material and growth temperature. Since the nitride semiconductor dots are formed and arranged in a direction, the nitride semiconductor layer may be grown as the single crystal. The nitride semiconductor layer may be grown to a thickness which is equal to or greater than a stress relaxation thickness. While the nitride semiconductor layer is growing as the single crystal, the nitride semiconductor dots are connected each other. A stress relaxation layer may be formed between the nitride semiconductor dots and the nitride semiconductor layer during the growth. The stress relaxation layer is continuously grown with the nitride semiconductor layer at the same temperature at which the nitride semiconductor layer is growing. In the stress relaxation layer, the dislocations generated on the interfaces between the nitride semiconductor dots and the nitride semiconductor layer are met and partially reduced. As an example, the stress relaxation layer may have a thickness of about 40 µm to about 50 µm. The thickness of the stress relaxation layer may correspond to a stress relaxation thickness at which the nitride semiconductor dots are connected each other.

The nitride semiconductor layer may be separated from the substrate by using one of commonly known techniques in the industries, such as a laser liftoff method, and then a freestanding nitride semiconductor substrate is obtained. The freestanding nitride semiconductor substrate includes the nitride semiconductor layer and the nitride semiconductor dots which may be presented near a surface of the nitride semiconductor layer. The stress relaxation layer may exist between the nitride semiconductor layer and the nitride semiconductor dots. In the freestanding nitride semiconductor substrate, the nitride semiconductor dots may have hexagonal shapes and exist on (or near) the surface of the nitride semiconductor layer which was initially interfaced with the substrate (e.g. sapphire) and separated from the substrate.

According to the method of growing the nitride semiconductor layer of the present exemplary embodiment, a thick GaN is grown on a sapphire substrate by using the HVPE method to fabricate a GaN substrate.

The sapphire substrate may be used as a heterogeneous substrate for growing the thick GaN. Because the sapphire has a hexagonal structure like GaN, and it is inexpensive and stable at the high temperatures. However, as described above, the sapphire may generate strain at the interface due to the differences between the lattice constants and the thermal expansion coefficients of the GaN and the sapphire. The interfacial strain generates the lattice defects and cracks in the crystal. Therefore, when the GaN layer is formed on the sapphire substrate, the cracks may be formed in the GaN layer.

According to the present exemplary embodiment, the GaN dots arranged in a direction are used to eliminate the possibility of the stress induced crack formation. To obtain a thick GaN layer, GaN is grown from the GaN dots in vertical and horizontal directions. A thickness of the thick GaN layer may be determined based on the sizes of the GaN dots.

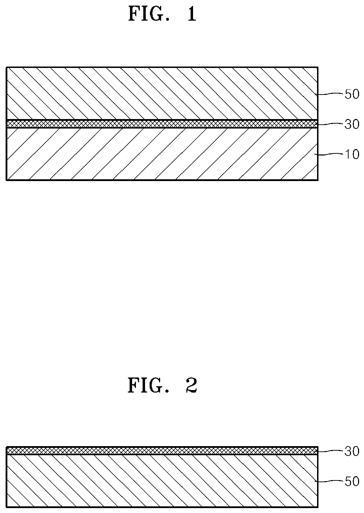

FIG. 1 is a schematic diagram illustrating a method of growing GaN on a sapphire substrate 10 according to the method of growing a nitride semiconductor layer of the present exemplary embodiment. FIG. 2 schematically shows a freestanding GaN substrate that is obtained by separating a thick GaN layer 50 from the sapphire substrate 10 in the structure shown in FIG. 1.

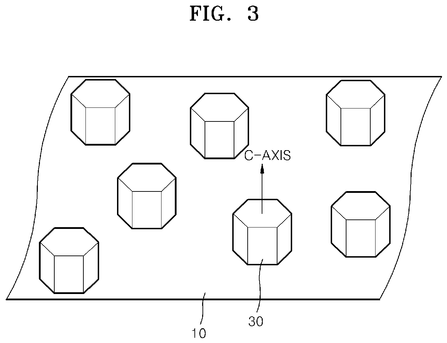

FIG. 3 is a perspective diagram of dots 30 formed on a substrate. The semiconductor layer is a nitride semiconductor layer (e.g., GaN). The substrate 10 is a sapphire substrate. The dots 30 are GaN dots.

Referring to FIG. 1, the sapphire substrate 10 is prepared in order to grow the GaN, which is one of the nitride semiconductors.

As shown in FIG. 3, GaN dots 30 are formed on the sapphire substrate 10. The GaN dots 30 may reduce the stress induced cracks that are generated due to the differences between the lattice constants or the thermal expansion coefficients of the sapphire substrate 10 and the thick GaN layer 50. The GaN dots 30 may be represented as a GaN dot layer as shown in FIG. 1.

In the inventive process to form the GaN dots 30, the sapphire substrate 10 is mounted in an HVPE reactor. A halide may be generated in the reactor. For example, GaCl may be synthesized from hydrogen chloride (HCl) and gallium (Ga) metal at a relatively high temperature. For example, GaCl may be processed with ammonia (NH₃) to grow the GaN dots 30 on the sapphire substrate 10.

According to the embodiments, a surface of the substrate (10) is treated to remove atoms. Seeds are formed by substitutionally filling vacancies generated by the removal of the atoms with at least one type of atom included in a material of the plurality of seeds. For example, if the semiconductor is GaN, the sapphire substrate 10 mounted in the HVPE reactor may be processed with HCl + NH₃ to remove oxygen from a surface of the sapphire substrate. Nitride seeds (e.g., nucleation sites) are formed on the substrate. According to the inventive method, aluminum nitride (AlN) seeds (not shown) are formed as seeds on which to grow the GaN dots 30 on the surface of the sapphire substrate 10. HCl and Ga may react with each other to form GaCl, and the GaCl may react with NH₃. Then, GaN is grown from the AlN seeds, and thus the GaN dots 30 are formed on the sapphire substrate. The GaN dots are grown at high temperatures, as specified in claim 1.

Referring to FIG. 3, the grown GaN dots 30 may have hexagonal shapes and may be arranged in one direction, for example, in a c-axis direction.

According to example embodiments, AlN nano dots may be formed on the sapphire substrate 10 as seeds, and GaN dots 30 are grown on the AlN nano dots. The AlN nano dots may be part of (e.g., inside) the GaN dots 30. In order to form AlN nano dots on a surface of a sapphire substrate 10, NH₃ and HCl may be simultaneously introduced into a chamber. Because the surface of the sapphire (Al₂O₃) substrate 10 may include oxygen dangling bonds, some oxygen may be removed by HCl, and the vacancies (originally occupied by the removed oxygen) may be filled by nitrogen thermally decomposed from NH₃. AlN nano dots may be randomly formed on the surface of the sapphire substrate 10 according to an oxygen substitution process.

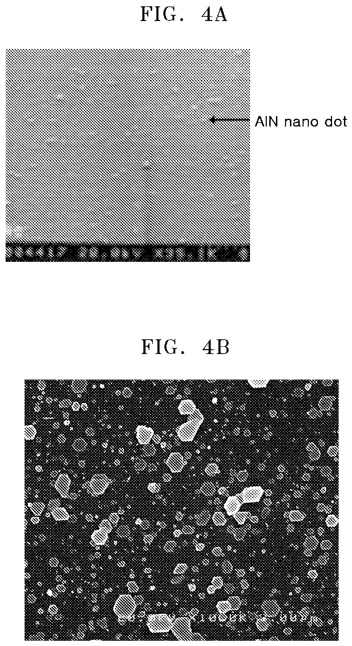

FIG. 4A is a scanning electron microscope (SEM) image of AlN nanodots on a sapphire substrate. Referring to FIG. 4A, the size of AlN nano dots may be controlled by various parameters including, for example, an amount/(flow rate x time period) of NH3 and HCl and/or a temperature of the sapphire substrate 10. As an example, AlN dots may be formed using a 3000 sccm flow rate of NH3 and a 200 sccm flow rate of HCl, at a sapphire substrate temperature of about 970°C, for about 5 minutes, in a reactor with a diameter of about 15 cm. The AlN nano dots may be randomly/uniformly formed on a sapphire substrate 10. The size of AlN nano dots may be in the range from about 10 nm to about 100 nm. Sizes and density of AlN nano dots may be determined according to temperature and time period. The size of GaN dots 30 and a thickness of the GaN layer 50 may be a function of the size of the AlN nano dots.

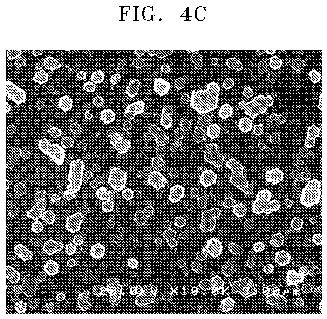

FIGS. 4B and 4C are scanning electron microscope (SEM) images which show the GaN dots 30 formed on the sapphire substrate 10. referring to FIGS. 4B and 4C, the GaN dots 30 may be arranged in the c-axis direction.

The GaN layer 50 may be grown on the GaN dots 30, which act as cores, and the growing speeds in vertical and horizontal directions are controlled by adjusting a ratio of the group III-V semiconductor material or growing temperature. Because the hexagonal GaN dots 30 shown in FIGS. 4B and 4C may be arranged in one direction, the GaN may be grown as a single crystal.

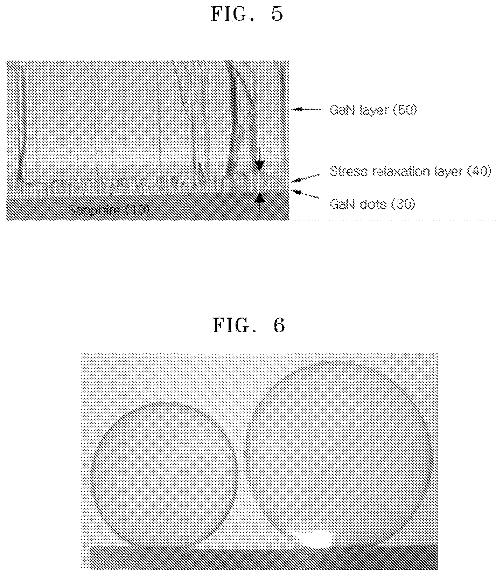

FIG. 5 is an optical microscope image showing a stress relaxation layer 40 formed between GaN dots 30 used as cores on a sapphire substrate 10, and a GaN layer 50 on both of the GaN dots 30 and the stress buffer layer 40. FIG. 5 may show that the stress relaxation layer 40 formed between the GaN dots 30 and the GaN layer 50 is formed when the GaN layer 50 is grown on the sapphire substrate by using the GaN dots 30 as cores. The stress relaxation layer typically is formed of the same material as the nitride semiconductor layer, but can be distinguished therefrom by having a different structure due to the presence of line defects or dislocations, as for instance can be recognized in FIG. 5. The stress relaxation layer 40 typically at least partially embeds the nitride dots

The GaN layer 50 is grown to a thickness that is equal to or greater than the stress relaxation thickness in which the GaN dots 30 are connected each other during the growing of the GaN layer 50. The stress relaxation layer (refer to 40 in FIG. 5) may be formed between the GaN dots 30 and the GaN layer (50) during the growing of the GaN layer 50. The stress relaxation layer 40 may be continuously grown at the same or substantially the same temperature as the GaN layer 50. When the GaN layer 50 is grown on the GaN dots 30, the dislocations are generated on the interfaces of the GaN dots 30. The GaN is grown from each GaN dot/core 30 and connected each other at some point at which the dislocations are partially removed and the stress relaxation layer (40) is formed.

The stress relaxation layer 40 may be grown from GaN dots 30 formed with/on AlN nano dots formed on a sapphire substrate 10 as seeds. AlN nano dots may be inside the GaN dots. According to example embodiments, the stress relaxation layer 40 may be grown from GaN dots formed directly on the sapphire substrate 10 without employing any seeds and the GaN dots may not include AlN nano dots. The stress relaxation layer 40 may have thickness of about 40 µm to about 50 µm, as described above. The thickness of the stress relaxation layer 40 may vary depending on the sizes of the GaN dots 30. For example, the thickness of the stress relaxation layer may be from about 1 µm to about 100 µm, inclusive, according to sizes of the dots 30.

When the GaN is grown using GaN dots, most of which have sizes of 0.4 µm or greater, the stress relaxation thickness (coalescence) in which the cores contact each other is about 40 µm to about 50 µm. The thickness of the stress relaxation layer 50 may correspond to the stress relaxation thickness.

Therefore, when the thickness of the GaN layer 50 is at least about 60 µm to about 70 µm or greater, the GaN layer 50 has a almost mirror surface and there is no stress induced crack.

As described above, when the GaN layer 50 is grown to the stress relaxation thickness or greater, the GaN layer 50 without cracks or defects in the crystal may be obtained with a desired thickness range.

In FIG. 2, the freestanding GaN substrate including the GaN layer 50 and the GaN dots 30 shown, which may be obtained by separating the GaN layer 50 with the desired thickness from the sapphire substrate 10 with the laser liftoff method. A high-efficient LED may be fabricated on the freestanding GaN substrate formed from the GaN dots 30 without stress induced cracks and defects. The freestanding GaN layer includes a surface which was the initially interface with the sapphire substrate 10 and became an open surface through the separation process. The GaN dots 30 may exist on/near the surface of the freestanding GaN layer and have hexagonal shapes. An LED may be formed on a side of the freestanding semiconductor substrate opposite the GaN dots 30. The substrate may include a frontside substrate layer including the semiconductor layer 50 and a backside substrate layer including the GaN dots 30.

In the laser liftoff method, a laser beam having a wavelength that is shorter than about 360 nm is employed. The GaN layer 50 may be irradiated by the laser beam to be separated from the sapphire substrate 10. The laser light source for performing the laser liftoff may be a third harmonic generation (about 321 nm) of Nd:YAG laser having a wavelength of about 1064 nm, KrF excimer laser having a wavelength of about 248 nm, or XeCl excimer laser having a wavelength of about 330 nm. When the laser beam having the wavelength of about 360 nm or shorter is irradiated on the sapphire substrate 10 and the GaN layer 50 formed on the substrate 10, the interface between the GaN layer 50 and the sapphire substrate 10 absorbs the laser beam. The GaN on the interface becomes Ga+1/2N², which causes the separation of the GaN layer 50 from the sapphire substrate 10.

The stress relaxation layer is not shown in FIGS. 1 and 2, because the stress relaxation layer may be formed during the growing process of the GaN layer 50 on the GaN dots 30 up to a desired thickness. The thickness of the stress relaxation layer may vary depending on the sizes of the GaN dots 30. Therefore, the stress relaxation layer may not be classified as a separate layer.

In the method of growing the nitride semiconductor layer according to the present exemplary embodiment, the nitride semiconductor may be grown using the HVPE method. When the GaN is grown on the sapphire substrate 10 by the HVPE method, the GaN dots 30 may be grown in-situ.

As mentioned previously, the GaN growing method on the sapphire substrate 10 with the GaN dots 30 may provide the high quality, thick GaN layer 50 without the cracks or defects which may be generated due to the differences between the lattice constants and the thermal expansion coefficients of the sapphire substrate and the GaN.

Referring to FIGS. 4B and 4C, most of the GaN dots (e.g., about 90 % of the GaN dots) have a size of about 0.4 µm or less. In FIG. 4C, most of the GaN dots (e.g., about 90 % of the GaN dots) have a size of about 0.4 µm to about 0.8 µm.

The GaN dots having relatively small sizes as shown in FIG. 4B are formed at a relatively low growing temperature, between 980°C and 990°C. The GaN dots having relatively large sizes as shown in FIG. 4C are formed at a relatively high growing temperature, namely at about 1040°C. The temperature for a desired size of GaN dots may be varied when the growing occurs at different conditions, because the size of GaN dots depends upon various factors. In FIGS. 4B and 4C, the GaN dots are formed after forming the AlN nano dot seeds as shown FIG. 4A on the sapphire substrate (10).

When the GaN dots have the sizes of 0.4 µm or less (as shown in FIG. 4B), the GaN layer grown using the relatively fine size of GaN dots as the cores becomes the mirror-like surface with a thickness of about 10 µm (or greater). Therefore, with the relatively fine size of GaN dots, the relatively thin GaN layer having a thickness of about 10 µm may be obtained.

When the GaN dots have the sizes, of 0.4 µm to 0.8 µm the GaN layer grown using the relatively coarse size of GaN dots as the cores may be grown up to relatively large thickness, for example, about 100 µm to about 1000 µm. This relatively thick GaN layer may be used as the freestanding GaN substrate for fabricating the high-efficient LED.

According to the method of growing the nitride semiconductor layer of the present embodiment, the GaN layer may be grown up to a thickness of about 300 µm or greater (more specifically, about 300 µm to about 400 µm).

As described above, when the GaN layer is grown using the relatively coarse size of GaN dots (for example, about 0.4 µm to about 0.8 µm), the GaN layer may have a thick thickness of about 300 µm or greater. This relatively thick GaN layer may be separated from the sapphire substrate, and the freestanding GaN substrate with a sufficient thickness may be obtained and used for fabricating a device on it.

When it is needed, the GaN layer may be grown to relatively thin (for example, a thickness of about 300 µm or less), without creating stress induced cracks and/or defects. Therefore, a high quality GaN layer, as well as a freestanding GaN substrate, with any desired thickness may be obtained by using the GaN dots according to the method of growing the nitride semiconductor layer of the present embodiment. When the GaN layer is grown by using the relatively coarse size of GaN dots (for example, about 0.4 µm or greater) as the cores, the stress relaxation thickness (coalescence), in which the cores are connected each other, is about 40 µm to about 50 µm. Therefore, when the GaN layer is grown by using the relatively coarse size of GaN dots as the cores, the GaN layer changes into the mirror-like status without forming the cracks at a relatively low thickness (for example, about 60 µm to about 70 µm).

As described above, when the thickness of the GaN layer is equal to or greater than a thickness of the stress relaxation layer (coalescence) at a given sizes of the GaN dots, the high quality GaN layer without cracks or defects can be obtained.

FIG. 6 is an optical image showing thick GaN/sapphire layers grown according to example embodiments with diameters of about 3 inches and about 4 inches. The GaN/sapphire structures are grown by using the GaN dots according to the method of growing the nitride semiconductor layer of the present embodiment.

It is clearly shown in FIG. 6 that the nitride semiconductor layer (i.e. the GaN layer) grown according to the method of growing the nitride semiconductor layer of the present embodiment has no cracks.

GaN layer growing on a sapphire substrate by using the method of growing a nitride semiconductor layer according to the embodiment of the present invention has been described above with the exemplary embodiment, but such should be considered in a descriptive sense only and not for purposes of limitation. Descriptions of features or aspects within each embodiment should typically be considered as available for other similar features or aspects in other embodiments. While an exemplary embodiment of the invention has been described, it should be apparent that modifications and variations thereto are possible, all of which fall within the scope of the invention as defined in the appended claims. With respect to the above description then, it is to be realized that the optimum relationships for the components and steps of the invention, including variations in order, form, content, function, manner of operation and method of fabrication, are deemed readily apparent and obvious to one skilled in the art, and all equivalent relationships to those illustrated in the drawings and described in the specification are intended to be encompassed by the present invention. The above description and drawings are illustrative of modifications that can be made without departing from the present invention, the scope of which is to be limited only by the following claims. Therefore, the foregoing is considered as illustrative only of the principles of the invention. Further, since numerous modifications and changes will readily occur to those skilled in the art, it is not desired to limit the invention to the exact construction and operation shown and described, and accordingly, all suitable modifications and equivalent are intended to fall within the scope of the invention as claimed.

## Claims

1. A method of growing a nitride semiconductor layer, the method comprising:
providing a Sapphire substrate (10) having a different lattice constant and different thermal expansion coefficients from the nitride semiconductor layer to be grown;
creating vacancies in the surface of the substrate by removing atoms;
forming a plurality of Aluminium Nitride, AlN, seeds in said vacancies;
growing a plurality of Gallium Nitride, GaN, semiconductor dots (30) from said seeds using a halide vapor phase epitaxy, HVPE, process; and
growing the nitride semiconductor layer (50) directly on said surface from the GaN semiconductor dots;
**characterised in that** the growing of the GaN semiconductor dots includes (i) growing at least 90% of the GaN semiconductor dots at about 1040°C to a size of 0.4 µm to 0.8 µm or (ii) growing at least 90% of the GaN semiconductor dots at about 980°C to about 990°C to a size less than or equal to 0.4 µm.

2. The method of claim 1, wherein the nitride semiconductor layer includes a stress relaxation layer (40), and wherein step of growing a nitride semiconductor layer includes forming the stress relaxation layer so that the nitride semiconductor dots (30) are connected to each other by the stress relaxation layer (40), wherein the growing of the nitride semiconductor layer includes growing the nitride semiconductor layer to a thickness greater than or equal to a thickness of the stress relaxation layer.

3. The method of claim 2, wherein the forming of the stress relaxation layer (40) includes forming the stress relaxation layer to a thickness of 1 µm to 100 µm.

4. The method of any of claims 1 through 3, wherein the growing the nitride semiconductor dots (30) includes growing the nitride semiconductor dots in a single direction perpendicular to the substrate surface.

5. The method of any of claims 1 through 4, wherein the growing of the GaN semiconductor dots (30) includes growing at least 90% of the GaN semiconductor dots to a size greater than or equal to 0.4 µm.

6. The method of claim 5, wherein the growing of the nitride semiconductor layer includes growing the nitride semiconductor layer to a thickness of 100 µm to 1000 µm.

7. The method of any of claims 1 through 4, wherein the growing of the GaN semiconductor dots includes growing at least 90% of the GaN semiconductor dots to a size less than or equal to 0.4 µm.

8. The method of claim 7, wherein the growing of the nitride semiconductor layer includes growing the nitride semiconductor layer to a thickness of less than or equal to 10 µm.

9. The method of any of claims 1 through 8, wherein the nitride semiconductor layer includes gallium nitride, GaN.

10. The method of claim 9, wherein the growing of the GaN semiconductor dots includes growing the GaN semiconductor dots to be hexagonal in shape.

11. The method of any of claims 1 through 10, wherein the nitride semiconductor layer (50) is separated from the substrate (10) by a laser liftoff method to be used as a nitride semiconductor substrate.

12. The method of claim 11, wherein the nitride semiconductor layer (50) is GaN.

## Patentansprüche

1. Verfahren zum Züchten einer Nitrid-Halbleiterschicht, wobei das Verfahren folgendes umfasst:
Bereitstellen eines Saphirsubstrats (10) mit einer sich von der zu züchtenden Nitrid-Halbleiterschicht unterscheidenden Gitterkonstante und sich unterscheidenden Wärmeausdehnungskoeffizienten;
Erzeugen von Lücken in der Oberfläche des Substrats durch Entfernung von Atomen;
Ausbilden einer Mehrzahl von Aluminiumnitridkeimen, AlN-Keimen, in den Lücken;
Züchten einer Mehrzahl von Halbleiterpunkten (30) aus Galliumnitrid, GaN, aus den Keimen unter Verwendung eines Halid-Gasphasenepitaxie-Prozesses, HVPE-Prozesses; und
Züchten der Nitrid-Halbleiterschicht (50) direkt auf der Oberfläche aus den GaN-Halbleiterpunkten;
**dadurch gekennzeichnet, dass** das Züchten der GaN-Halbleiterpunkte folgendes umfasst: (i) Züchten von mindestens 90% der GaN-Halbleiterpunkte bei etwa 1040 °C auf eine Größe von 0,4 µm bis 0,8 µm, oder (ii) Züchten von mindestens 90% der GaN-Halbleiterpunkte bei etwa 980 °C bis etwa 990 °C auf eine Größe von kleiner oder gleich 0,4 µm.

2. Verfahren nach Anspruch 1, wobei die Nitrid-Halbleiterschicht eine Entspannungsschicht (40) aufweist, und wobei der Schritt des Züchtens einer Nitrid-Halbleiterschicht das Ausbilden der Entspannungsschicht umfasst, so dass die Nitrid-Halbleiterpunkte (30) durch die Entspannungsschicht (40) miteinander verbunden sind, wobei das Züchten der Nitrid-Halbleiterschicht das Züchten der Nitrid-Halbleiterschicht auf eine Dicke umfasst, die größer oder gleich der Dicke der Entspannungsschicht ist.

3. Verfahren nach Anspruch 2, wobei das Ausbilden der Entspannungsschicht (40) das Ausbilden der Entspannungsschicht auf eine Dicke von 1 µm bis 100 µm umfasst.

4. Verfahren nach einem der Ansprüche 1 bis 3, wobei das Züchten der Nitrid-Halbleiterpunkte (30) das Züchten der Nitrid-Halbleiterpunkte in eine einzige Richtung umfasst, die senkrecht zu der Substratoberfläche ist.

5. Verfahren nach einem der Ansprüche 1 bis 4, wobei das Züchten der GaN-Halbleiterpunkte (30) das Züchten von mindestens 90% der GaN-Halbleiterpunkte auf eine Größe von größer oder gleich 0,4 µm umfasst.

6. Verfahren nach Anspruch 5, wobei das Züchten der Nitrid-Halbleiterschicht das Züchten der Nitrid-Halbleiterschicht auf eine Dicke von 100 µm bis 1000 µm umfasst.

7. Verfahren nach einem der Ansprüche 1 bis 4, wobei das Züchten der GaN-Halbleiterpunkte das Züchten von mindestens 90% der GaN-Halbleiterpunkte auf eine Größe von kleiner oder gleich 0,4 µm umfasst.

8. Verfahren nach Anspruch 7, wobei das Züchten der Nitrid-Halbleiterschicht das Züchten der Nitrid-Halbleiterschicht auf eine Dicke von kleiner oder gleich 10 µm umfasst.

9. Verfahren nach einem der Ansprüche 1 bis 8, wobei die Nitrid-Halbleiterschicht Galliumnitrid, GaN, umfasst.

10. Verfahren nach Anspruch 9, wobei das Züchten der GaN-Halbleiterpunkte das Züchten der GaN-Halbleiterpunkte in eine hexagonale Form umfasst.

11. Verfahren nach einem der Ansprüche 1 bis 10, wobei die Nitrid-Halbleiterschicht (50) von dem Substrat (10) durch ein Laser-Lift-Off-Verfahren getrennt wird, zur Verwendung als ein Nitrid-Halbleitersubstrat.

12. Verfahren nach Anspruch 11, wobei die Nitrid-Halbleiterschicht (50) GaN ist.

## Revendications

1. Procédé de croissance d'une couche semi-conductrice à nitrure, le procédé comprenant les étapes consistant à :
fournir un substrat de saphir (10) ayant une constante de réseau différente et des coefficients de dilatation thermique différents de ceux de la couche semi-conductrice à nitrure à faire croître ;
créer des vides à la surface du substrat en enlevant des atomes ;
former une pluralité de graines de nitrure d'aluminium, AlN, dans lesdits vides ;
faire croître une pluralité de points semi-conducteurs (30) de nitrure de gallium, GaN, à partir desdites graines en utilisant un procédé d'épitaxie en phase vapeur d'halogénure, HVPE, et
faire croître la couche semi-conductrice à nitrure (50) directement sur ladite surface à partir des points semi-conducteurs de GaN ;
**caractérisé en ce que** la croissance des points semi-conducteurs de GaN comprend les étapes consistant à (i) faire croître au moins 90 % des points semi-conducteurs de GaN à environ 1040 °C jusqu'à une taille comprise entre 0,4 µm et 0,8 µm ou (ii) faire croître au moins 90 % des points semi-conducteurs de GaN entre environ 980 °C et environ 990 °C jusqu'à une taille inférieure ou égale à 0,4 µm.

2. Procédé selon la revendication 1, la couche semi-conductrice à nitrure comprenant une couche de relaxation des contraintes (40), et l'étape de croissance d'une couche semi-conductrice à nitrure comprenant l'étape consistant à former la couche de relaxation des contraintes de sorte que les points de semi-conducteur de nitrure (30) soient connectés les uns aux autres par la couche de relaxation des contraintes (40), la croissance de la couche semi-conductrice à nitrure comprenant l'étape consistant à faire croître la couche semi-conductrice à nitrure jusqu'à une épaisseur supérieure ou égale à une épaisseur de la couche de relaxation des contraintes.

3. Procédé selon la revendication 2, la formation de la couche de relaxation des contraintes (40) comprenant l'étape consistant à former la couche de relaxation des contraintes à une épaisseur comprise entre 1 µm et 100 µm.

4. Procédé selon l'une quelconque des revendications 1 à 3, la croissance des points semi-conducteurs de nitrure (30) comprenant l'étape consistant à faire croître les points semi-conducteurs de nitrure dans une seule direction perpendiculaire à la surface du substrat.

5. Procédé selon l'une quelconque des revendications 1 à 4, la croissance des points semi-conducteurs de GaN (30) comprenant l'étape consistant à faire croître au moins 90 % des points semi-conducteurs de GaN à une taille supérieure ou égale à 0,4 µm.

6. Procédé selon la revendication 5, la croissance de la couche semi-conductrice à nitrure comprenant l'étape consistant à faire croître la couche semi-conductrice à nitrure jusqu'à une épaisseur comprise entre 100 µm et 1 000 µm.

7. Procédé selon l'une quelconque des revendications 1 à 4, la croissance des points semi-conducteurs de GaN comprenant l'étape consistant à faire croître au moins 90 % des points semi-conducteurs de GaN à une taille inférieure ou égale à 0,4 µm.

8. Procédé selon la revendication 7, la croissance de la couche semi-conductrice à nitrure comprenant l'étape consistant à faire croître la couche semi-conductrice à nitrure jusqu'à une épaisseur inférieure ou égale à 10 µm.

9. Procédé selon l'une quelconque des revendications 1 à 8, la couche semi-conductrice à nitrure comprenant du nitrure de gallium, GaN.

10. Procédé selon la revendication 9, la croissance des points semi-conducteurs de GaN comprenant l'étape consistant à faire croître les points semi-conducteurs de GaN pour qu'ils aient une forme hexagonale.

11. Procédé selon l'une quelconque des revendications 1 à 10, la couche semi-conductrice à nitrure (50) étant séparée du substrat (10) par un procédé de décollage au laser pour être utilisée comme substrat semi-conducteur à nitrure.

12. Procédé selon la revendication 11, la couche semi-conductrice à nitrure (50) comprenant du GaN.
